(19)

Europäisches
Patentamt
European
Patent Office
Office européen
des brevets

(11) **EP 4 729 953 A1**

(12) **EUROPEAN PATENT APPLICATION**

(43) Date of publication:
**22.04.2026 Bulletin 2026/17**

(21) Application number: **25206544.6**

(22) Date of filing: **03.10.2025**

(51) International Patent Classification (IPC):
***G01R 27/22*** *(2006.01)*

(52) Cooperative Patent Classification (CPC):
**G01R 27/22;** G01R 31/52

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority: **04.10.2024 SE 2450990**

(71) Applicant: **Volvo Truck Corporation
405 08 Göteborg (SE)**

(72) Inventors:
• **NEILSON, Rohan
VÄSTERÅS (SE)**
• **BARKAH, Dani
ESKILSTUNA (SE)**

(74) Representative: **Ström & Gulliksson AB
P.O. Box 4188
203 13 Malmö (SE)**

(54) **DEVICE AND METHOD FOR DETERMINING CONDUCTIVITY**

(57) A measurement device (100) for determining the conductivity of a coolant in a liquid cooling system is provided. The measurement device comprises a reference resistance (Rk) arranged in parallel with a fluid path (26) of a coolant conduit (22) of the liquid cooling system (20); a voltage sensor (110) configured to measure a voltage (V2) across the reference resistance (Rk); and a control unit (120) configured to: obtain the voltage (V2) from the first voltage sensor (110); obtain a primary voltage (V1) across a primary fluid path (25) of the coolant conduit (22) of the liquid cooling system (20); and determine the conductivity of the coolant based on the voltage (V2), the primary voltage (V1), and the reference resistance (Rk).

FIG. 2

EP 4 729 953 A1

## Description

## TECHNICAL FIELD

The disclosure relates generally to electrical systems. In particular aspects, the disclosure relates to devices and methods for determining conductivity. The disclosure can be applied to heavy-duty vehicles, such as trucks, buses, and construction equipment, among other vehicle types. Although the disclosure may be described with respect to a particular vehicle, the disclosure is not restricted to any particular vehicle.

## BACKGROUND

Voltages in modern electrified vehicles must be contained to prevent a significant hazard via the potential for dangerous electrical currents. Ensuring this hazard will always be safely isolated and contained throughout a long life of the vehicle or during/after a collision is not always practical mechanically and therefore isolation resistance monitoring systems are employed to monitor the resistance to electrical leakage, thereby allowing systems to be shut down before or when a potential for dangerous current arises.

Isolation resistance measurement systems are typically configured to monitor the resistance to electrical current leakage from the traction voltage poles to the vehicle chassis; usually from an entire voltage bus connecting multiple batteries, inverters etc. Where individual devices and/or sub-systems can be isolated from the main voltage bus their impact on the total value can be assessed but this has proven to come with some limitations. Further, isolation of such devices and/or sub-systems may not be possible during operation of the associated vehicle.

Fuel cell stacks and/or immersion cooled batteries typically require liquid coolant and this coolant is exposed to significant voltages. Electrical conductivity through the coolant can carry potentially dangerous leakage currents or facilitate corrosion or electrolysis, generally forcing the use of specialty low-conductivity coolants.

Isolation resistance monitoring systems, which measure the resistance to electrical current leakage between the high voltage buses and chassis, are typically employed in electrified vehicles to ensure that the safety and integrity of the electrical network carrying hazardous voltage is maintained.

In the case of electrical leakage through the cooling system, conductivity measurements can provide an independent fail-safe ensuring the fluid's integrity..

Conductivity sensors can be useful for ensuring the fluid adequately prevents electrolysis and/or corrosion but are expensive, usually need to make/attempt compensations for temperature, and are typically quite susceptible to contamination.

In view of above, there is a need for improvement for determining electrical properties of electrical systems, in particular where electrically conducting fluid paths are present.

## SUMMARY

According to a first aspect of the disclosure, a measurement device for determining the conductivity of a coolant in a liquid cooling system is provided. The measurement device comprises a reference resistance arranged in parallel with a fluid path of a coolant conduit of the liquid cooling system; a voltage sensor configured to measure a voltage across the reference resistance; and a control unit configured to: obtain the voltage from the first voltage sensor; obtain a primary voltage across a primary fluid path of the coolant conduit of the liquid cooling system; and determine the conductivity of the coolant based on the voltage, the primary voltage, and the reference resistance. The first aspect of the disclosure may seek to improve existing solutions in terms of safety and simplicity for determining the conductivity of a coolant of a liquid cooling system. A technical benefit may include a reasonably compact and reliable measurement device being less susceptible to contamination.

The measurement device may be passive, i.e. the measurement device does not include an excitation source. A technical benefit may include a more simple and less costly measurement device. Another major benefit to being passive is to avoid/reduce susceptibility to electrode contamination and corrosion. The polarization source or "current electrodes" are not the bottleneck, they are located outside the "cell", and exist unaffected anyway while the "voltage electrodes" are both generally well matched with the local coolant potential and at least weakly coupled with one typically being bonded to ground potential also.

The measurement device may be active, i.e. the measurement device comprises an excitation source. A technical benefit may include the provision of additional information, and to allow measurements to be performed when the main power source, such as a fuel cell system, is disconnected from a main voltage bus. Further, an active measurement device may be capable of measuring properties of the coolant independently of current leakage. Further, technical benefits of active measurement devices include the possibility to operate on a complete resistance path thereby obtaining additional information about the distribution of isolation resistance and possible fault-tracing and/or diagnostics. If a measurement device is positioned in a noisy location such as proposed herein then knowledge of the interference source can be used to reject the interference but also to confirm ground continuity and potentially, depending on the electrode configuration, provide a measure of a resistance or current leakage along the path concerned, in addition to the local fluid property measurement.

Optionally in some examples, including in at least one preferred example, the control unit is further configured to determine the conductivity of the coolant based on geometric data of the primary fluid path. A technical benefit may include broader conductivity and resistance information and low cost. For example, rather than measuring an independent coolant cell a coolant path is used for measurements which further enables a check for ground continuity.

Optionally in some examples, including in at least one preferred example, the measurement device further comprises: a temperature sensor configured to determine the temperature of the coolant. A technical benefit may include further accuracy of the measurement device, as an actual temperature may also be considered.

Optionally in some examples, including in at least one preferred example, the control unit is further configured to determine the conductivity of the coolant for a plurality of different temperatures. A technical benefit may include calculating a temperature dependency of the conductivity, which further contributes to the accuracy of the measurements.

Optionally in some examples, including in at least one preferred example, the control unit is further configured to determine the resistance through the coolant along a plurality of different coolant paths and which may be at different temperature. It should be noted that conductivity and resistance may be used interchangeably since conductivity is not directly measured, but rather a resistance measurement made specific to geometry. A technical benefit may include dividing the resistances off a complete vehicle measurement and potentially identify an issue on one of the paths. The measurement device, being simple and low-cost, may make this possible rather than being an outcome.

Optionally in some examples, including in at least one preferred example, the control unit is further configured to determine the conductivity as a function of temperature. A technical benefit may include a robust and comprehensive representation of the conductivity, thereby allowing the conductivity to be determined based on a measured temperature only.

Optionally in some examples, including in at least one preferred example, the control unit is further configured to estimate a coolant temperature based on the measured conductivity. A technical benefit may include reducing the need for physical temperature sensors.

Optionally in some examples, including in at least one preferred example, the measurement device further comprises: a total voltage sensor configured to obtain the total voltage across the entire coolant conduit; and wherein the control unit is further configured to: obtain the primary voltage from the total voltage. A technical benefit may include reduced uncertainty and improved accuracy.

Optionally in some examples, including in at least one preferred example, the total voltage sensor forms part of an isolation resistance monitoring device or other control module. For example, the source voltage may be approximately the negative-chassis voltage plus fuel cell stack voltage. In another example, the voltage is from an isolation resistance monitoring device and calculation based on peak-peak amplitude, rate of change, or similar, and with or without averaging to avoid the need to know absolute local values or symmetry. A technical benefit may include simple construction and implementation of the measurement device, partly relying on the isolation resistance measurement device already available.

Optionally in some examples, including in at least one preferred example, the measurement device further comprises: a first probe configured to be mounted at a first position in the coolant conduit; a second probe configured to be mounted at a second position in the coolant conduit; and an intermediate probe configured to be mounted at an intermediate position between the first position and the second position in said coolant conduit such that a first fluid path is formed between the first probe and the intermediate probe, and a second fluid path is formed between the intermediate probe and the second probe. A technical benefit may include the possibility to provide the measurement device as a relatively small and stand-alone component.

Optionally in some examples, including in at least one preferred example, the measurement device further comprises: a primary voltage sensor configured to measure the primary voltage across the primary fluid path. A technical benefit may include improved robustness, as a dedicated voltage sensor is used to measure the primary voltage.

Optionally in some examples, including in at least one preferred example, the distance between the first probe and the intermediate probe is greater than 10 mm. A technical benefit may include improved accuracy and reliability, reducing noise and other factors that may affect measurements negatively, mainly susceptibility to contamination or bridging.

Optionally in some examples, including in at least one preferred example, the distance between the second probe and the intermediate probe is greater than 10 mm. A technical benefit may include improved accuracy and reliability, reducing noise and other factors that may affect measurements negatively.

Optionally in some examples, including in at least one preferred example, the measurement device further comprises: a coolant conduit accessory, and wherein the first probe, the second probe, and the intermediate probe form part of the coolant conduit accessory. A technical benefit may include a simple and efficient construction of the measurement device.

Optionally in some examples, including in at least one preferred example, the coolant conduit accessory comprises a conduit connector, a strainer, or a valve. A technical benefit may include improved utilization of required components for the liquid cooling system, thereby reducing complexity and facilitating installation.

Optionally in some examples, including in at least one preferred example, the measurement device further comprises: a coolant conduit lining, and wherein the reference resistance is provided by said coolant conduit lining. A technical benefit may include simplification of the installation process.

Optionally in some examples, including in at least one preferred example, the measurement device further comprises: a temperature sensor configured to determine the temperature of the coolant; a total voltage sensor in the form of an isolation resistance monitoring device configured to obtain the total voltage across the entire coolant conduit; wherein the control unit is arranged remote from the coolant conduit and further configured to: determine the conductivity of the coolant based on geometric data of the primary fluid path; determine the conductivity of the coolant for a plurality of different temperatures and as a function of temperature; and obtain the primary voltage from the total voltage. A technical benefit may include improved packing and assembly of the measurement device.

According to a second aspect of the disclosure, an energy storage system is provided. The energy storage system comprises: a liquid cooling system configured to cool at least one electrode of the energy storage system; and a measurement device of the first aspect for determining conductivity of a coolant in the liquid cooling system. The second aspect of the disclosure may seek to improve existing solutions in terms of safety and simplicity for determining the conductivity of a coolant of a liquid cooling system. A technical benefit may include a reasonably passive measurement device which is compact and which allows the conductivity to be determined without measuring a significant resistance.

Optionally in some example, including in at least one preferred example, the measurement device is arranged remote from the at least one electrode of the energy storage system. A technical benefit may include improved packing and assembly of the measurement device.

Optionally in some example, including in at least one preferred example, the energy storage system is a fuel cell system or an immersion cooled battery. A technical benefit may include improved utilization of the measurement device, and further improved monitoring and safety handling of common energy storage systems.

According to a third aspect of the disclosure, a vehicle is provided. The vehicle comprises at least one of the measurement device of the first aspect and the energy storage system of the second aspect. The third aspect of the disclosure may seek to improve existing solutions in terms of safety and simplicity for determining the conductivity of a coolant of a liquid cooling system. A technical benefit may include a reasonably passive measurement device which is compact and which allows the conductivity to be determined without providing excitation (and potentially only measuring a single low voltage).

According to a fourth aspect of the disclosure, a method for determining conductivity of a coolant in a liquid cooling system is provided. The method comprises: obtaining a primary voltage across a primary fluid path of a coolant conduit of the liquid cooling system; obtaining a measured voltage across a reference resistance arranged in parallel with a second fluid path of the coolant conduit of the liquid cooling system; and determining the conductivity of the coolant based on the measured voltage, the primary voltage, and the reference resistance. The fourth aspect of the disclosure may seek to improve existing solutions in terms of safety and simplicity for determining the conductivity of a coolant of a liquid cooling system. A technical benefit may include a reasonably passive measurement device which is compact and which allows the conductivity to be determined without measuring a significant resistance.

Optionally in some examples, including in at least one preferred example, the method further comprises: determining the conductivity of the coolant based on geometric data of the primary fluid path. A technical benefit may include a fast and reliable calculation of the conductivity without requiring further measurements.

Optionally in some examples, including in at least one preferred example, the method further comprises: determining the conductivity as a function of temperature. A technical benefit may include a robust and comprehensive representation of the conductivity, thereby allowing the conductivity to be estimated at other locations.

The disclosed aspects, examples (including any preferred examples), and/or accompanying claims may be suitably combined with each other as would be apparent to anyone of ordinary skill in the art. Additional features and advantages are disclosed in the following description, claims, and drawings, and in part will be readily apparent therefrom to those skilled in the art or recognized by practicing the disclosure as described herein.

**BRIEF DESCRIPTION OF THE DRAWINGS**

Examples are described in more detail below with reference to the appended drawings.

FIG. 1 is an exemplary side view of a vehicle according to an example.
FIG. 2 is an exemplary diagram of an energy storage system, comprising a liquid cooling system and a measurement device, according to an example.
FIGS. 3A-C are schematic diagrams of a measurement device according to different examples.
FIGS. 4A-C are exemplary side views of a measurement device according to various examples.
FIGS. 5A-F are exemplary diagrams of an energy storage system, comprising a liquid cooling system and a measurement device, according to different example.
FIG. 6 is a flow chart of a method according to an example.

## DETAILED DESCRIPTION

The detailed description set forth below provides information and examples of the disclosed technology with sufficient detail to enable those skilled in the art to practice the disclosure.

The present disclosure aims to provide a low-cost conductivity indicator based on establishing the resistance in coolant paths while running a vehicle. Coolant plays a crucial role in the efficient operation of liquid cooled energy storage systems, such as fuel cells and immersion cooled batteries. While the coolant is regulating the temperature within the energy storage system, it is designed to prevent overheating and to ensure optimal performance. Additionally, the coolant contributes to maintaining the thermal balance.

The conductivity of the coolant will affect the magnitude of potential leak currents through the coolant, electrolysis gas evolution and corrosion..

The present disclosure aims to provide an improved measurement device that is configured to effectively monitor the integrity of the coolant system. The measurement device has a simple construction thereby removing the need for measuring resistance, since a coolant passage may be exploited as a kind of contained and well-defined cell to remove the need for careful control of the electrodes.

The general idea is to split the coolant conduit into two fluid lengths, and assuming the coolant of each fluid length to provide a specific conductivity-dependent resistance. By arranging a known resistance in parallel with one of the fluid length, and by knowing the ratio between the two fluid lengths, the conductivity of the coolant is determined. In general, the resistance is determined within a coolant path having known dimensions. This allows for passively measuring the polarization created by existing devices rather than providing excitation/-polarization. This also allows for exploiting large existing dimensions and potentials instead of creating a measurement cell with precise electrodes. Further, it allows specific paths of interest to be measured to gain indication of the related fluid property, allowing improved diagnostics of safety considerations such as ground continuity.

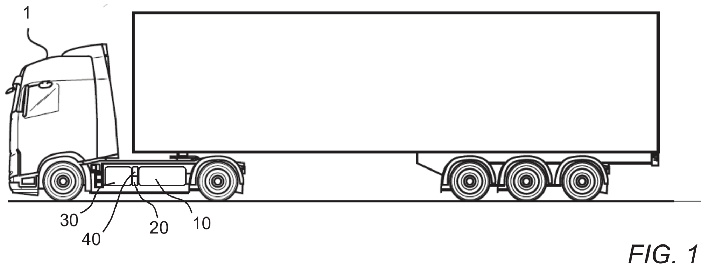

FIG. 1 is an exemplary view of a vehicle **1** according to an example. The vehicle **1,** shown as a truck, may be any type of suitable vehicle **1.** The vehicle **1** comprises an energy storage system **10** comprising a liquid cooling system **20** and one or more electrical machines **30** being powered by the energy storage system **10.** The vehicle **1** further comprises at least one measurement device **100** being configured to determine the conductivity of a coolant of the liquid cooling system **20.**

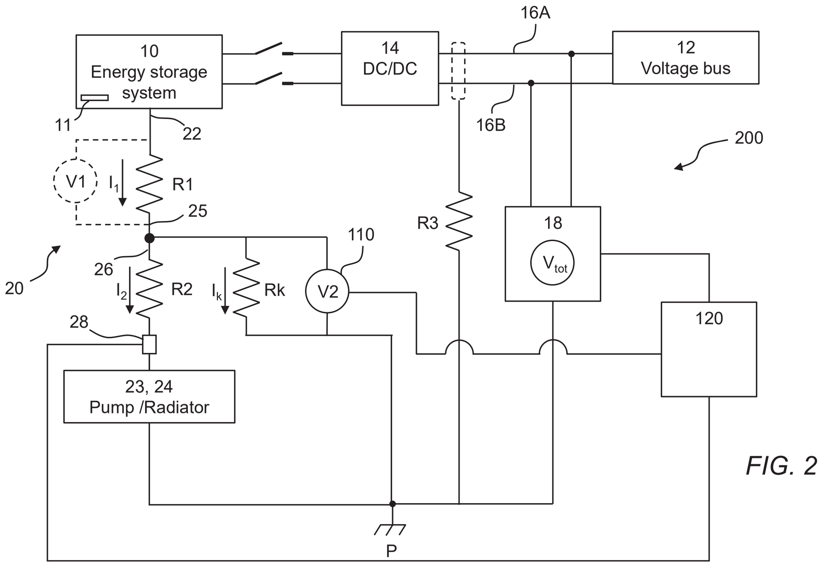

FIG. 2 is an exemplary and schematic view of an energy storage system **10** according to an example. The energy storage system **10,** preferably being a fuel cell system or an immersion cooled battery, is configured to provide power to one or more electrical loads through a voltage bus **12.** In some examples, typically including a fuel cell system, a DC/DC converter **14** is provided to connect the energy storage system **10** to the voltage bus **12.** In the shown example, the voltage bus **12** is formed by two electrical poles **16A, 16B.**

The energy storage system **10** comprises a liquid cooling system **20.** The liquid cooling system **20** comprises one or more cooling conduits **22** arranged to guide coolant through the liquid cooling system **20,** and to pass the coolant across high voltage components that may function like electrodes **11.** The cooling system **20** may further comprise additional components such as a coolant pump **23,** a radiator **24,** etc.

A measurement device **100** is provided to determine the resistance of one or more coolant paths and from this determine the conductivity of the coolant flowing in the liquid cooling system **20,** and in particular the coolant flowing the cooling conduit **22.** The measurement device **100** comprises a known reference resistance **Rk,** a voltage sensor **110,** and a control unit **120.** The measurement device **100** operates as follows.

The cooling conduit **22** is virtually split into to two fluid paths **25, 26.** The primary fluid path **25** extends from the energy storage system **10,** such as the fuel cell stack, to the second fluid path **26.** The second fluid path **26** extends from the primary fluid path **25** to ground **P,** or at least to a grounded component such as the pump **23** or the radiator **24.** The measurement device **100** is connected to the cooling conduit **22** at the interface between the primary fluid path **25** and the second fluid path **26** at a fixed position such that the geometrical ratio between the primary fluid path **25** and the second fluid path **26** is well defined.

The coolant of the primary fluid path **25** forms a primary resistance **R1**, and the coolant of the second fluid path **26** forms a second resistance **R2**. The reference resistance **Rk** is arranged in parallel with the second resistance **R2,** and the voltage sensor **110** is configured to measure the voltage across the reference resistance **Rk.**

In the shown example, an isolation resistance monitoring device **18** is provided to measure the total voltage **Vtot** between the voltage bus **12** and the chassis **P** of the vehicle **1,** representing ground.

The control unit **120** of the measurement device **100** is configured to resolve the voltage division created across **R1**, **R2, Rk.** Generally this will be equivalent to using the proportionality of path **25** and 26, derivatives, or highpass filtered voltage values in the voltage division to avoid the need to know the total voltage across the divider or across the **R1** resistor (**V1**). In some examples **V1** is measured and it can generally also be estimated. The control unit **120** may be configured to determine a primary voltage **V1** across the primary resistance **R1** of the primary fluid path **25** from the total voltage **Vtot** and by subtracting the measured voltage **V2**, i.e. **V1 = Vtot - V2.**

The control unit **120** is further configured to determine the current **I** flowing through the reference resistance **Rk**, using **I=V2/R2** and consequently determine the primary resistance as **R1 = V1/I**. Generally, the current, voltage, and resistance is different in each leg so the voltage divider equation (or **I₁ = I₂ + I_k**) is needed to form a system of equations and then **R1 = C\*R2** or similar is needed to reduce this to a single equation. Voltage division can also solve this equation using **Vtot** instead of **V1** so the **V1 = Vtot - V2** step is not needed.

In addition, the control unit **120** of the measurement device **100** is further configured to determine the conductivity of the coolant based on geometrical data, such as the length *L* of the primary fluid path **25** as well as the cross-sectional area *A* of the primary fluid path **25**. From these parameters, it is possible to determine the conductivity σ of the coolant as: $\sigma = \frac{L}{A} \times \frac{1}{R1}$.

As is shown in **FIG. 2** a temperature sensor **28** is provided. The temperature sensor **28** is preferably arranged at the coolant conduit **22**, such as inside the primary fluid path **25** or inside the second fluid path **26**. The temperature sensor **28** is connected to the control unit **120** which is configured to determine the actual temperature of the coolant, and to link the actual temperature to the obtained conductivity of the coolant. Hence, by performing a plurality of conductivity measurements at different temperatures, such as during startup and/or shutdown of the energy storage system 10, the control unit **120** may be configured to map the variable conductivity to temperature, and the control unit **120** may consequently be configured to determine the conductivity as a function of temperature.

Normally, although not shown in **FIG. 2** there is another conduit **22** returning coolant which may be provided with a similar measurement device **100**. This gives a more complete picture of the resistance of the coolant and removing this from the total resistance measured by the isolation resistance monitoring device **200** can improve insight into the rest of the vehicle **1**. Since this other conduit(s) will normally be at a different temperature, this is another source of temperature dependence (inlet and outlet data) and this allows some cross-checks to be performed (i.e. temperature change vs inlet and outlet data).

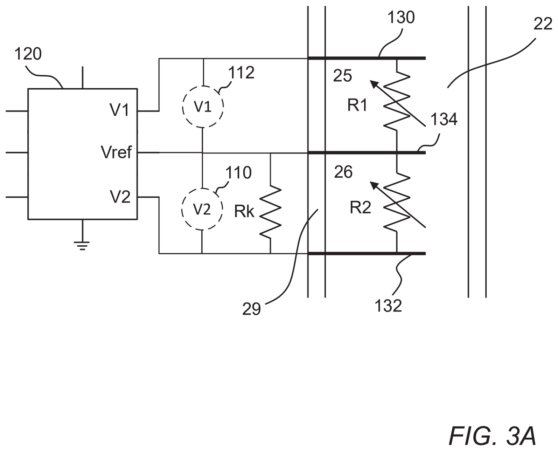

In **FIG. 3A** an example of a measurement device **100** is shown. The measurement device **100** is, similarly to the measurement device described with reference to **FIG. 2**, configured to determine the conductivity of coolant flowing in a coolant conduit **22** of a liquid cooling system **20**.

The measurement device **100** comprises a first probe **130**, a second probe **132**, and an intermediate probe **134**. The probes **130, 132, 134** are configured to be mounted in the cooling conduit **22** at fixed positions such that a primary fluid path **25** is formed between the first probe **130** and the intermediate probe **134**, and a second fluid path **26** is formed between the intermediate probe

**134** and the second probe **132**. The coolant of the primary fluid path **25** will cause a primary resistance **R1**, and the coolant of the second fluid path **26** will cause a second resistance **R2**. Due to the temperature dependency of the coolant's resistivity, as well as other conditions such as ions dissolving in the coolant, the primary resistance **R1** and the second resistance **R2** are varying.

The measurement device **100** further comprises a reference resistance **Rk** arranged in parallel with the second resistance **R2**. The measurement device **100** further comprises a voltage sensor **110** configured to measure the voltage **V2** across the reference resistance **R2**.

The measurement device **100** also comprises a primary voltage sensor **112** configured to measure a primary voltage **V1** across the primary resistance **R1**.

The measurement device **100** comprises a control unit **120** which is connected to the first probe **130**, the second probe **132**, and the intermediate probe **134**. It should be noted that the measurement device **100** and/or control unit **120** may be some other controller or module primarily dedicated for some other purpose.

In a similar manner as described above, from the primary voltage **V1**, the second voltage **V2**, and the reference resistance **Rk** the control unit **120** is configured to determine the primary resistance **R1**. From this primary resistance **R1**, and knowing the length *L* of the first fluid path **25** as well as the cross-sectional area A of the first fluid path **25**, the control unit **120** is configured to determine the conductivity of the coolant flowing in the coolant conduit **22**.

Although not shown in **FIG. 3A**, it should be understood that the measurement device **100** may comprise one or more temperature sensors **28** in order to map the temperature dependency of the conductivity. The temperature sensor **28** may form part of another equipment and it may be configured to measure the temperature directly, or indirectly by measuring the same temperature of fluid but outside the conduit **22**.

According to one example, the reference resistance **Rk** is integrated in the coolant conduit **22**, for example by embedding a conductive liner **29** in the second fluid path **26**. An insulating liner material or sleeve may be combined with conductive wrap or sleeve in a wrapped/laminated construction and finally encapsulated in insulating material to create formed hoses with an in-built short.

Alternatively a turn of conductive strip at a reference location followed by combination with a complete insulating wrap(s) could produce a wrap-formed hose that is normally insulating but with a hermitic feedthrough to a conductive band at a specific location.

Similarly a wire and/or conductive strip may be woven radially/circumferentially in a hose of braided construction to create multiple leakage hermitically sealed but electrically conductive pathways at a specific location.

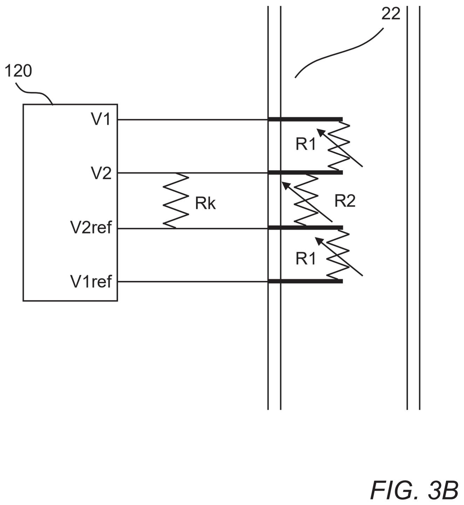

In **FIG. 3B** an example of a measurement device **100** is shown. Here the second voltage (between 3rd/4th pole) may be populated with data from other systems forcing some requirements (e.g. voltages published on CAN or measured by a module receiving voltage from the isolation resistance monitoring device etc.) By taking two voltage measurements these requirements/dependencies can be avoided. This can also be distributed as a conventional 4-pole conductivity cell (i.e R1 is split above and below R2 and V1 measures across the complete cell as shown in **FIG. 3B**).This can also form a more direct conductivity measurement with a local (even on board) cell characteristic.

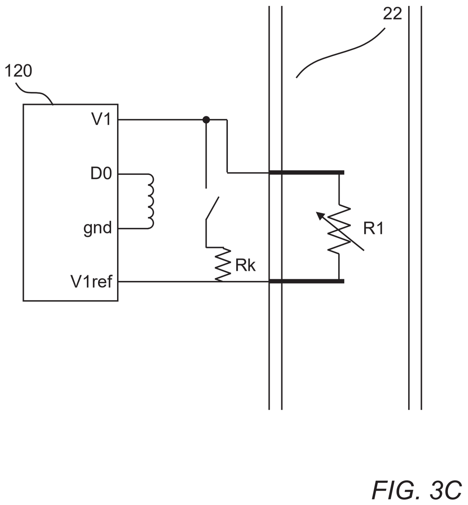

In **FIG. 3C** another example of a measurement device **100** is shown. Assuming the measurement does not significantly impact the polarization more globally then the stand-alone measurement device can be condensed into a two-electrode setup where the degree of localized depression of polarization is proportional to the ratio R1:Rk.

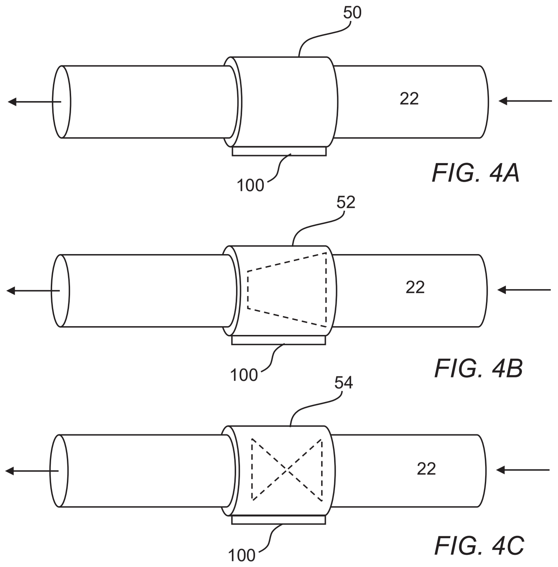

In **FIG. 4A-C** different examples of a measurement device **100** are shown. In **FIG. 4A**, the measurement device **100** is integrated or forms part of a conduit connector **50** used to connect two parts of a coolant conduit **22.** For example, the conduit connector **50** is a metallic hose connector or joiner wired to the reference resistance. Optionally a protective cover may be provided to keep it from contacting anything or being accessed. It may be mountable e.g. bolted to chassis and the connector **50** may also provide grounding. Taking this further a conductive tube may be pressed through a non-conductive housing, ideally forcing contact with a mating terminal or connection in the process. Similarly it may appeal to integrate this function into a hose connector and integrating a hermitic feedthrough which may be over-molded in place, encapsulated/potted, or sealed through crushing/crimping or elastomer seals. An insulated wire may extend some length into a hose, preferably with an exposed ring at the end, in order to reach some desired location which is distant from a convenient access point. Wire spirals known for static dissipation could alternatively be exploited to carry charge within a highly insulating hose material.

In **FIG. 4B,** the measurement device **100** is integrated or forms part of a strainer **52** arranged inside the coolant conduit **22.**

In **FIG. 4C,** the measurement device **100** is integrated or forms part of a valve **54** arranged inside the coolant conduit **22.**

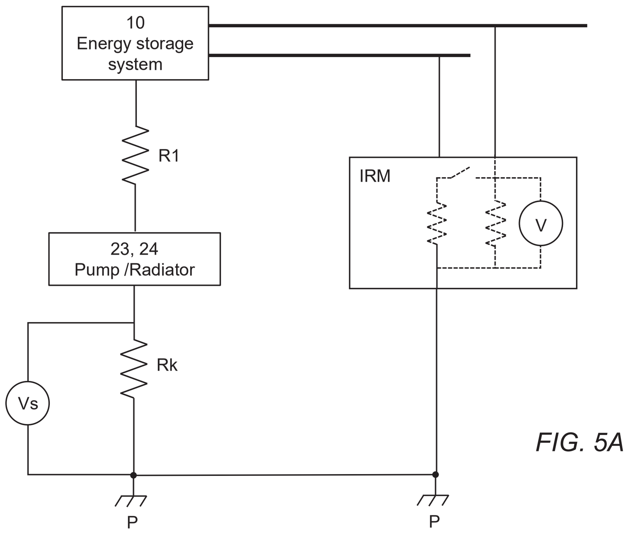

Some examples of measuring devices **100,** and how to perform measurements, will be explained with reference to **FIGS. 5A-F.** Starting in **FIG. 5A,** an integrated passive and externally polarized 2-pole conductivity measurement device with virtual/external third pole is shown. A component **23, 24** carrying electrical leakage from the coolant is grounded via a shunt **Rk.** The voltage at the component **23, 24** is according to the division **Rk/(R1+Rk)** and is safely low unless shunt **Rk** opens in which case **Vs** goes out of range. In such a case the isolation resistance monitoring device **IRM** will detect an isolation resistance improvement but the system can detect this via **Vs**. Conductivity is calculated from **R1=k/σ, R1** is calculated from **V1/R1 = Vs/Rk** and **Vs** from **IRM** and/or fuel cell.

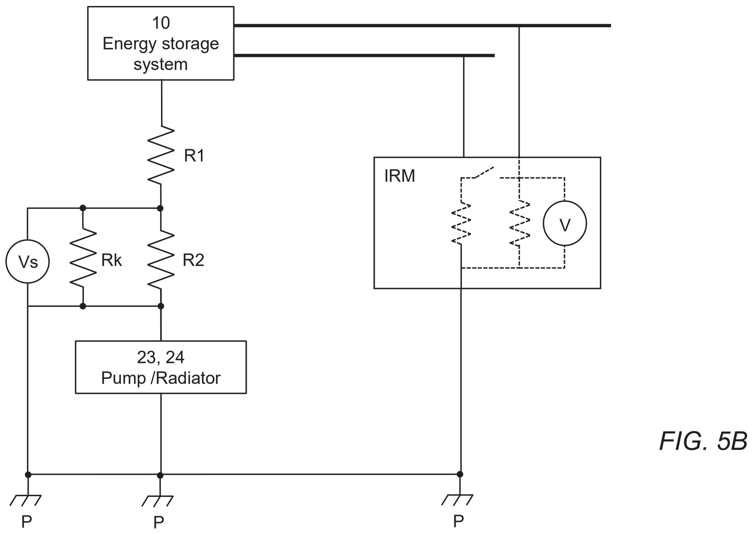

In **FIG. 5B** a measurement device is shown keeping the components **23, 24** grounded, using 2 poles with external/virtual third and fourth poles. Where the ratio **R1:R2** is known/exploited or **R2>>Rk** the parallel known resistor can be moved above the component **23, 24** to keep it at ground potential and using a conventional ground scheme. The voltage **Vs** can be determined according to the division **Rs∥R2/(R1+Rs∥R2)** where **Rs∥R2≈Rs** or **R1/R2 = C.** Parallel ground paths around **Vs** may be arranged with **Vs** references chassis or the component. This gives out-of-range or no-potential respectively if the component **23, 24** loses ground connection and either way no-potential if **IRM** chassis/ground continuity is lost. **Vs** could also be floated, splitting **R1** to become a 4-pole sensor. Conductivity is calculated from **R1** or **R2=k/σ,R1** is calculated from **V1/R1 = Vs/(Rs∥R2)** and **V1** from **IRM** and/or fuel cell system **10.**

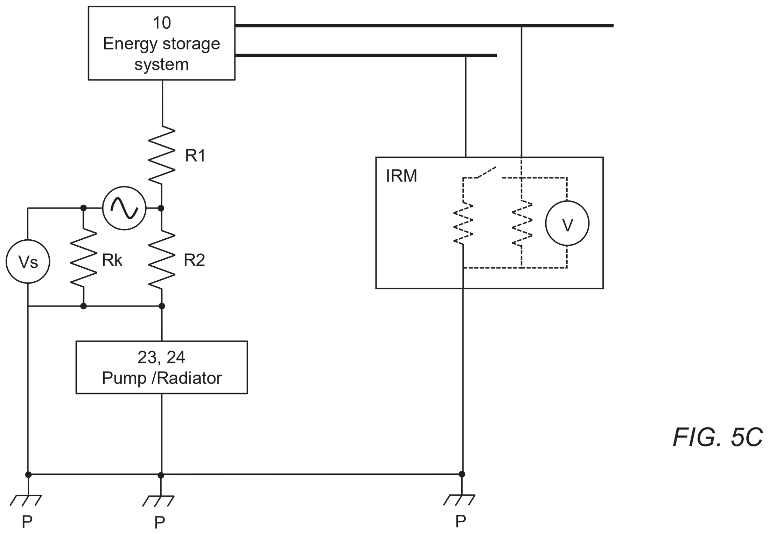

In **FIG. 5C** another example is shown, representing an active excitation using a 2-pole measurement device with virtual/external third and fourth poles. In addition to assessing the alternating polarization generated by the **IRM** when the fuel cell system is connected an excitation voltage/current may also be supplied as in more conventional sensor configurations. If not using a passive mode when possible, the interference from the **IRM** is according to the above examples and overlays over the simpler and more symmetric excited wave which can be at a significantly different frequency. **R2** is then measured independent of **R1** by rejecting the noise by sample averages, masking, etc. The leakage current can be calculated from the noise/interference and **R1** can be inferred from this and the source voltage and/or proportionality with **R2**. Active mode is more likely just used when contactors are open.

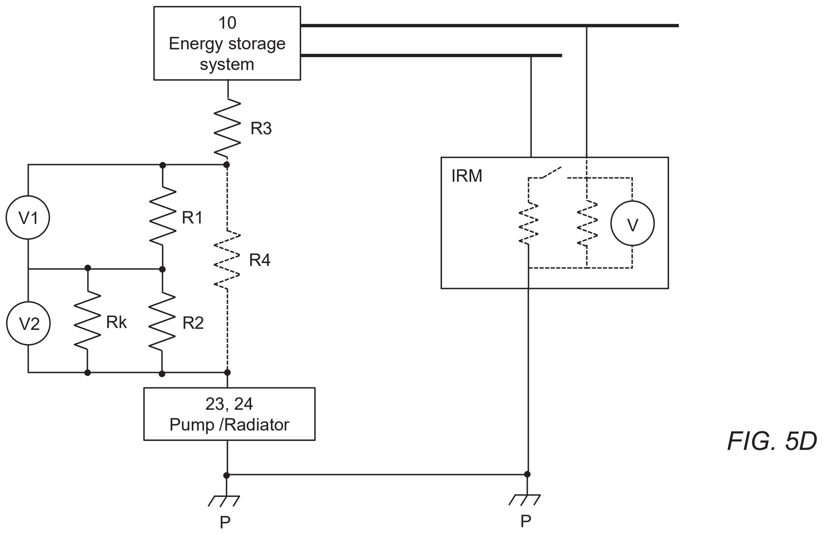

In **FIG. 5D** another example is shown, here represented by a stand-alone passive sensor. The above methods populate the second voltage (3rd/4th pole) with data from other systems forcing some requirements (**Vs** published on CAN or measured by a module receiving **V** from the **IRM** etc.) By taking two voltage measurements these requirements or dependencies can be avoided. This can also be distributed as a conventional 4-pole conductivity cell (i.e. **R1** is split above and below **R2** and **V1** measures across the complete cell). This can also form a more direct conductivity measurement with a local (even onboard) cell characteristic rather than being dependent on **R3** or **R4** at right. This means that if **R4** exists and without known proportionality to **R1/R2** then **R3** and **R4** are not measured (though could be estimated).

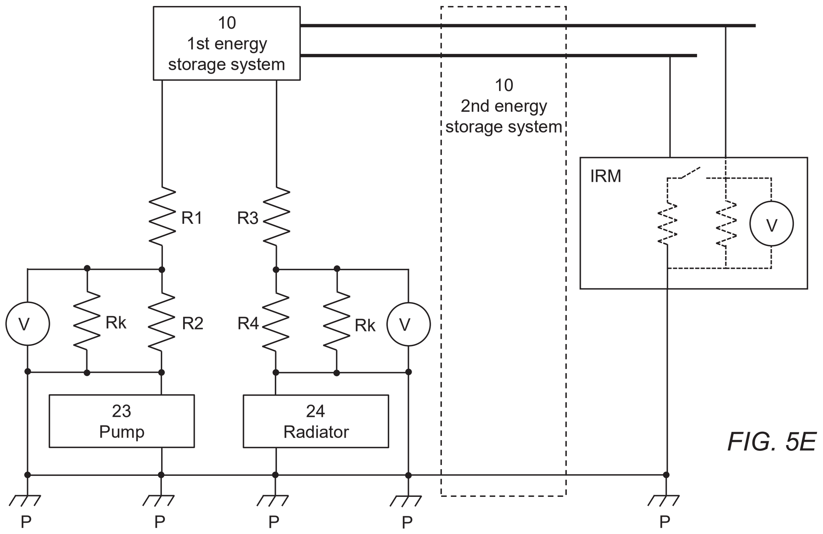

In **FIG. 5E** another example is shown, implementing multiple measurements. Here **R1** and **R2** are at one temperature while **R3** and **R4** are at another temperature giving a second reference for conductivity vs temperature (in addition to changes in **R1/R2** or **R3/R4** temperature). Furthermore another system could even be measured separately rather than joined giving further measurements for comparison. If a hose in the **R1** path of the second system is replaced with a wrong material for example or has a short to chassis then this measurement will deviate from the others which reasonably agree. The correct system can be shut down to maintain integrity if needed and the location of the fault causing isolation resistance problems can be indicated.

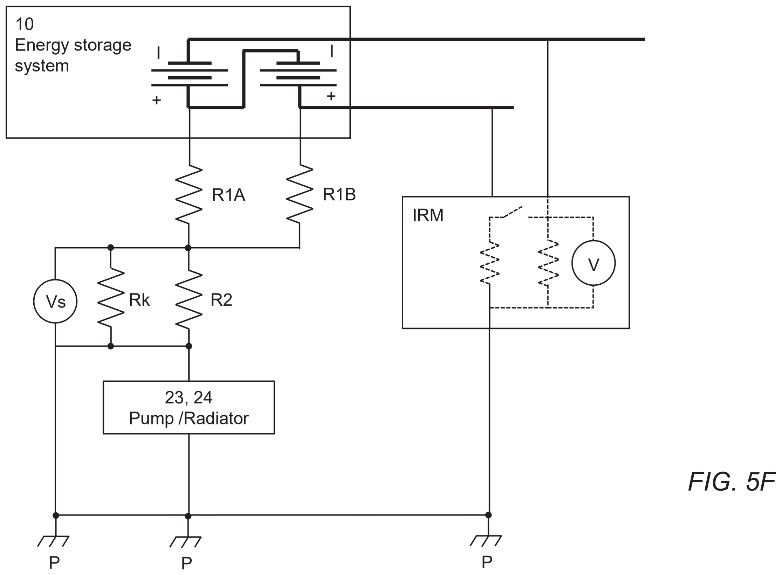

In **FIG. 5F** another example is shown, allowing filtering and/or processing of the total voltage, including further analysis. Here the fuel stack (or battery pack) is split into series stacks (modules) each with a separate inlet and outlet for heated coolant. These are joined after some distance to provide resistance which prevents electrolysis etc. **Vtot** is not a single value but (**VNC+** left stack voltage) at **R1A** and (**VNC+** both stacks) at **R1B.** If the stacks are equal and **R1A=R1B** then **Vtot = VNC+ 0.75*Vstack.** But stacks may be unequal and vary in voltage while **R1A/R1B** may be unequal and can be different temperatures. To combat zero error/drift and constant discrepancies (and because it is easier to threshold against ground loss) it then appeals to use the voltage division: Δ**V** vs Δ**Vtot** = Δ**VNC+ C*ΔVstack** and since Δ**Vstack** is normally or often negligible or zero within the window of Δ**VNCchange**, or in some cases may step or ripple much faster, then **C*Vstack** is typically not used and can be checked. Further, apparent deviations in an over defined system e.g. **(R1A‖R1B):R2** and **C** (voltage offset /symmetry deviation) may be used to indicate a voltage deviance if **R1A/R1B** temperatures are known or temperature difference and even the temperature at **R1A** and **R1B** if the voltage split and **R2** temperature is known, potentially removing the need for two separate physical outlet temperature sensors.

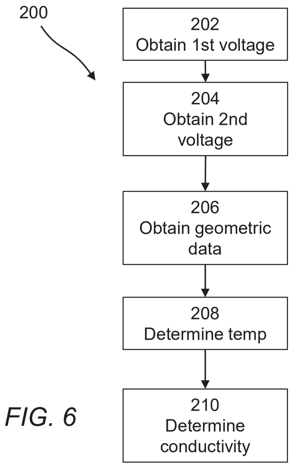

**FIG. 6** is a flow chart illustrating a method **200** for determining the conductivity of a coolant flowing inside a coolant conduit of a liquid cooling system. The method **200** comprises obtaining **202** a primary voltage across a primary fluid path of a coolant conduit of the liquid cooling system, and obtaining **204** a measured second voltage across a reference resistance arranged in parallel with a second fluid path of the coolant conduit of the liquid cooling system. The method **200** further comprises obtaining **206** geometric data, such as the length and cross-sectional area of the primary fluid path, and optionally determining **208** the temperature of the coolant. The method **200** further comprises determining **210** the conductivity of the coolant based on the measured voltage, the primary voltage, and the reference resistance, and optionally determining the conductivity as a function of temperature.

Generally, the geometric data is constant and known. Preferably, unlike conventional sensors singular direct values are not compared but instead the method **200** operates by comparing peak-to-peak amplitude or values referenced against window averages to remove the effects of asymmetry and/or possibly compare to expected asymmetry.

**Example 1.** A measurement device (100) for determining the conductivity of a coolant in a liquid cooling system, comprising: a reference resistance (Rk) arranged in parallel with a fluid path (26) of a coolant conduit (22) of the liquid cooling system (20); a voltage sensor (110) configured to measure a voltage (V2) across the reference resistance (Rk); and a control unit (120) configured to: obtain the voltage (V2) from the first voltage sensor (110); obtain a primary voltage (V1) across a primary fluid path (25) of the coolant conduit (22) of the liquid cooling system (20); and determine the conductivity of the coolant based on the voltage (V2), the primary voltage (V1), and the reference resistance (Rk).

**Example 2.** The measurement device of Example 1, wherein the control unit (120) is further configured to determine the conductivity of the coolant based on geometric data *(A, L)* of the fluid path (26).

**Example 3.** The measurement device of Example 1 or 2, wherein a coolant resistance (R2) is sufficiently higher than the reference resistance (Rk) so as to become negligible.

**Example 4.** The measurement device of any of Examples 1-3, further comprising a temperature sensor (28) configured to determine the temperature of the coolant.

**Example 5.** The measurement device of Example 4, wherein the control unit (120) is further configured to determine the conductivity of the coolant for a plurality of different temperatures.

**Example 6.** The measurement device of Example 5, wherein the control unit (120) is further configured to determine the conductivity as a function of temperature.

**Example 7.** The measurement device of any of Examples 1-6, further comprising: a total voltage sensor (18) configured to obtain the total voltage (Vtot) across the entire coolant conduit (22); and wherein the control unit (120) is further configured to: obtain the primary voltage (V1) from the total voltage (Vtot).

**Example 8.** The measurement device of Example 7, wherein the total voltage sensor (18) forms part of an isolation resistance monitoring device (18).

**Example 9.** The measurement device of any of Examples 1-6, further comprising: a first probe (130) configured to be mounted at a first position in the coolant conduit (22); a second probe (132) configured to be mounted at a second position in the coolant conduit (22); and an intermediate probe (134) configured to be mounted at an intermediate position between the first position and the second position in said coolant conduit (22) such that a primary fluid path (25) is formed between the first probe (130) and the intermediate probe (134), and a second fluid path (26) is formed between the intermediate probe (134) and the second probe (132).

**Example 10.** The measurement device of Example 9, further comprising: a primary voltage sensor

(112) configured to measure the primary voltage (V1) across the primary fluid path (25).

**Example 11.** The measurement device of any of Examples 9-10, wherein the distance between the first probe (130) and the intermediate probe (134) is greater than 10 mm.

**Example 12.** The measurement device of any of Examples 9-11, wherein the distance between the second probe (132) and the intermediate probe (134) is greater than 10 mm.

**Example 13.** The measurement device of any of Examples 9-12, further comprising a coolant conduit accessory (50, 52, 54), and wherein the first probe (130), the second probe (132), and the intermediate probe (134) form part of the coolant conduit accessory (50, 52, 54)

**Example 14.** The measurement device of Example 13, wherein the coolant conduit accessory (50, 52, 54) comprises a conduit connector (50), a strainer (52), or a valve (54).

**Example 15.** The measurement device of any of Examples 9-14, further comprising: a coolant conduit lining (29), and wherein the reference resistance (Rk) is provided by said coolant conduit lining (29).

**Example 16.** The device of Example 1, further comprising: a temperature sensor (28) configured to determine the temperature of the coolant; a total voltage sensor (18) in the form of an isolation resistance monitoring device (18) configured to obtain the total voltage (Vtot) across the entire coolant conduit (22); wherein the control unit (120) is arranged remote from the coolant conduit (22) and further configured to: determine the conductivity of the coolant based on geometric data (A, L) of the primary fluid path (25); determine the conductivity of the coolant for a plurality of different temperatures and as a function of temperature; and obtain the primary voltage (V1) from the total voltage (Vtot).

**Example 17.** An energy storage system (10), comprising: a liquid cooling system (20) configured to cool at least one electrode of the energy storage system (10); and a measurement device (100) of any of Examples 1-16 for determining conductivity of a coolant in the liquid cooling system.

**Example 18.** The energy storage system (10) of Example 17, wherein the measurement device (100) is arranged remote from the at least one electrode of the energy storage system (10).

**Example 9.** The energy storage system (10) of any of Examples 17-18, wherein the energy storage system (10) is a fuel cell system or an immersion cooled battery.

**Example 20.** The energy storage system (10) of any of examples 17-19, wherein the liquid cooling system (20) comprises multiple conduits (22) and wherein the energy storage system (10) comprises one or more measurement devices (100) configured to determine the conductivity of the coolant in at least two conduits (22).

**Example 21.** The energy storage system (10) of Example 20, wherein the measured resistance of the two or more conduits (22) are separated from a total isolation resistance of the energy storage system (10).

**Example 22.** The energy storage system (10) of any of Examples 17-21, wherein the control unit (120) is further configured to cross-check the overdetermined system for discrepancies.

**Example 23.** The energy storage system (10) of any of Examples 17-22, wherein the control unit (120) is further configured to estimate the temperature of the coolant based on the determined conductivity.

**Example 24.** The energy storage system (10) of any of Examples 17-23, wherein the control unit (120) is further configured to use voltage symmetry deviation to estimate a source voltage where not known.

**Example 25.** A vehicle comprising at least one of the measurement device according to any of Examples 1-16 and the energy storage system of any of Examples 17-24.

**Example 26.** A method for determining conductivity of a coolant in a liquid cooling system, comprising: obtaining a primary voltage across a primary fluid path of a coolant conduit of the liquid cooling system; obtaining a measured voltage across a reference resistance arranged in parallel with a second fluid path of the coolant conduit of the liquid cooling system; and determining the conductivity of the coolant based on the measured voltage, the primary voltage, and the reference resistance.

**Example 27.** The method of Example 26, further comprising: determining the conductivity of the coolant based on geometric data of the primary fluid path.

**Example 28.** The method of any of Examples 26-27, further comprising: determining the conductivity as a function of temperature.

The terminology used herein is for the purpose of describing particular aspects only and is not intended to be limiting of the disclosure. As used herein, the singular forms "a," "an," and "the" are intended to include the plural forms as well, unless the context clearly indicates otherwise. As used herein, the term "and/or" includes any and all combinations of one or more of the associated listed items. It will be further understood that the terms "comprises," "comprising," "includes," and/or "including" when used herein specify the presence of stated features, integers, actions, steps, operations, elements, and/or components, but do not preclude the presence or addition of one or more other features, integers, actions, steps, operations, elements, components, and/or groups thereof.

It will be understood that, although the terms first, second, etc., may be used herein to describe various elements, these elements should not be limited by these terms. These terms are only used to distinguish one element from another. For example, a first element could be termed a second element, and, similarly, a second element could be termed a first element without departing from the scope of the present disclosure.

Relative terms such as "below" or "above" or "upper" or "lower" or "horizontal" or "vertical" may be used herein to describe a relationship of one element to another element as illustrated in the Figures. It will be understood that these terms and those discussed above are intended to encompass different orientations of the device in addition to the orientation depicted in the Figures. It will be understood that when an element is referred to as being "connected" or "coupled" to another element, it can be directly connected or coupled to the other element, or intervening elements may be present. In contrast, when an element is referred to as being "directly connected" or "directly coupled" to another element, there are no intervening elements present.

Unless otherwise defined, all terms (including technical and scientific terms) used herein have the same meaning as commonly understood by one of ordinary skill in the art to which this disclosure belongs. It will be further understood that terms used herein should be interpreted as having a meaning consistent with their meaning in the context of this specification and the relevant art and will not be interpreted in an idealized or overly formal sense unless expressly so defined herein.

It is to be understood that the present disclosure is not limited to the aspects described above and illustrated in the drawings; rather, the skilled person will recognize that many changes and modifications may be made within the scope of the present disclosure and appended claims. In the drawings and specification, there have been disclosed aspects for purposes of illustration only and not for purposes of limitation, the scope of the disclosure being set forth in the following claims.

**Claims**

1.  A measurement device (100) for determining the conductivity of a coolant in a liquid cooling system, comprising:

    a reference resistance (Rk) arranged in parallel with a fluid path (26) of a coolant conduit (22) of the liquid cooling system (20);
    a voltage sensor (110) configured to measure a voltage (V2) across the reference resistance (Rk); and
    a control unit (120) configured to:

    obtain the voltage (V2) from the first voltage sensor (110);
    obtain a primary voltage (V1) across a primary fluid path (25) of the coolant conduit (22) of the liquid cooling system (20); and
    determine the conductivity of the coolant based on the voltage (V2), the primary voltage (V1), and the reference resistance (Rk).

2.  The measurement device of claim 1, wherein the control unit (120) is further configured to determine the conductivity of the coolant based on geometric data *(A, L)* of the primary fluid path (25).

3.  The measurement device of any of claims 1-2, further comprising:
    a temperature sensor (28) configured to determine the temperature of the coolant.

4.  The measurement device of claim 3, wherein the control unit (120) is further configured to determine the conductivity of the coolant for a plurality of different temperatures and to determine the conductivity as a function of temperature.

5.  The measurement device of any of claims 1-4, further comprising:
    a total voltage sensor (18) configured to obtain the total voltage (Vtot) across the entire coolant conduit (22); and wherein the control unit (120) is further configured to:
    obtain the primary voltage (V1) from the total voltage (Vtot).

6.  The measurement device of any of claims 1-4, further comprising:

    a first probe (130) configured to be mounted at a first position in the coolant conduit (22);
    a second probe (132) configured to be mounted at a second position in the coolant conduit (22); and
    an intermediate probe (134) configured to be mounted at an intermediate position between the first position and the second position in said coolant conduit (22) such that a primary fluid path (25) is formed between the first probe (130) and the intermediate probe (134), and a second fluid path (26) is formed between the intermediate probe (134) and the second probe (132).

7.  The measurement device of claim 6, further comprising:
    a primary voltage sensor (112) configured to measure the primary voltage (V1) across the primary fluid path (25).

8.  The measurement device of any of claims 6-7, wherein the distance between the first probe (130) and the intermediate probe (134) is greater than 10 mm, and wherein the distance between the second probe (132) and the intermediate probe (134) is greater than 10 mm.

9.  The measurement device of any of claims 6-8, further comprising a coolant conduit accessory (50, 52, 54), and wherein the first probe (130), the second probe (132), and the intermediate probe (134) form part of the coolant conduit accessory (50, 52, 54).

10. The device of claim 1, further comprising:

a temperature sensor (28) configured to determine the temperature of the coolant;
a total voltage sensor (18) in the form of an isolation resistance monitoring device (18) configured to obtain the total voltage (Vtot) across the entire coolant conduit (22);
wherein the control unit (120) is arranged remote from the coolant conduit (22) and further configured to:

determine the conductivity of the coolant based on geometric data (A, L) of the primary fluid path (25);
determine the conductivity of the coolant for a plurality of different temperatures and as a function of temperature; and
obtain the primary voltage (V1) from the total voltage (Vtot).

11. An energy storage system (10), comprising:

a liquid cooling system (20) configured to cool at least one electrode of the energy storage system (10); and
a measurement device (100) of any of claims 1-10 for determining conductivity of a coolant in the liquid cooling system.

12. The energy storage system (10) of claim 11, wherein the measurement device (100) is arranged remote from the at least one electrode of the energy storage system (10).

13. A vehicle comprising at least one of the measurement device according to any of claims 1-10 and the energy storage system of any of claims 11-12.

14. A method for determining conductivity of a coolant in a liquid cooling system, comprising:

obtaining a primary voltage across a primary fluid path of a coolant conduit of the liquid cooling system;
obtaining a measured voltage across a reference resistance arranged in parallel with a second fluid path of the coolant conduit of the liquid cooling system; and
determining the conductivity of the coolant based on the measured voltage, the primary voltage, and the reference resistance.

15. The method of claim 14, further comprising:

determining the conductivity of the coolant based on geometric data of the primary fluid path.

FIG. 1

FIG. 2

EP 4 729 953 A1

FIG. 3A

FIG. 3B

FIG. 3C

*FIG. 4A*

*FIG. 4B*

*FIG. 4C*

EP 4 729 953 A1

FIG. 5A

FIG. 5B

FIG. 5C

EP 4 729 953 A1

FIG. 5D

FIG. 5E

FIG. 5F

200

202
Obtain 1st voltage

204
Obtain 2nd voltage

206
Obtain geometric data

208
Determine temp

210
Determine conductivity

*FIG. 6*

Europäisches
Patentamt

European
Patent Office

Office européen
des brevets

# EUROPEAN SEARCH REPORT

**Application Number**

EP 25 20 6544

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | CN 110 718 707 A (GEELY AUTOMOBILE RES INSTITUTE NINGBO CO LTD ET AL.) 21 January 2020 (2020-01-21) * the whole document * | 1-15 | INV. G01R27/22 |
| A | US 2021/263093 A1 (HACKL DIETER [DE]) 26 August 2021 (2021-08-26) * paragraph [0062] - paragraph [0107]; figures 3-10 * | 1-15 | |
| A | KR 2013 0047075 A (HYUNDAI KEFICO CORP [KR]) 8 May 2013 (2013-05-08) * paragraph [0015] - paragraph [0041]; figures 1, 4 * | 1-15 | |
| A | US 3 993 945 A (WARMOTH DENIS ET AL) 23 November 1976 (1976-11-23) * column 3, line 5 - column 5, line 29; figures 1-2 * | 1-15 | |

**TECHNICAL FIELDS SEARCHED (IPC)**

G01R

The present search report has been drawn up for all claims

| Place of search | Date of completion of the search | Examiner |
|---|---|---|
| Munich | 3 March 2026 | Mazagão Guerreiro, R |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 25 20 6544

This annex lists the patent family members relating to the patent documents cited in the above-mentioned European search report.
The members are as contained in the European Patent Office EDP file on
The European Patent Office is in no way liable for these particulars which are merely given for the purpose of information.

03-03-2026

| Patent document cited in search report | | Publication date | Patent family member(s) | | Publication date |
|---|---|---|---|---|---|
| CN 110718707 | A | 21-01-2020 | NONE | | |
| US 2021263093 | A1 | 26-08-2021 | CN | 113311231 A | 27-08-2021 |
| | | | DE | 102020104956 B3 | 06-05-2021 |
| | | | EP | 3872503 A1 | 01-09-2021 |
| | | | US | 2021263093 A1 | 26-08-2021 |
| KR 20130047075 | A | 08-05-2013 | NONE | | |
| US 3993945 | A | 23-11-1976 | DE | 2533943 A1 | 19-02-1976 |
| | | | GB | 1517697 A | 12-07-1978 |
| | | | JP | S5139096 A | 01-04-1976 |
| | | | JP | S5846698 B2 | 18-10-1983 |
| | | | NL | 7509233 A | 04-02-1976 |
| | | | US | 3993945 A | 23-11-1976 |

EPO FORM P0459

For more details about this annex : see Official Journal of the European Patent Office, No. 12/82